Europäisches Patentamt

European Patent Office

Office européen des brevets

(11) Publication number : **0 485 086 A1**

## (12) EUROPEAN PATENT APPLICATION

(21) Application number : 91309729.1

(22) Date of filing : 22.10.91

(51) Int. Cl.⁵ : **H01L 23/485, H01L 21/90**

(30) Priority : 31.10.90 US 608065

(43) Date of publication of application :
13.05.92 Bulletin 92/20

(84) Designated Contracting States :
DE ES FR GB IT

(71) Applicant : AMERICAN TELEPHONE AND
TELEGRAPH COMPANY
550 Madison Avenue
New York, NY 10022 (US)

(72) Inventor : Chew, Hongzong
2859 Edgemont Drive
Allentown, Pennsylvania 18103 (US)

Inventor : Harrus, Alain Simon
517 Patricia Lane
Palo Alto, California 94373 (US)
Inventor : Hills, Graham William
100 Vasona Oaks Drive
Santa Clara, California 95030 (US)
Inventor : Thoma, Morgan Jones
359 Village Walk Drive
Macungie, Pennsylvania 18062 (US)
Inventor : Yu, Chen-Hua Douglas
1019 Hillview Drive
Allentown, Pennsylvania 18103 (US)

(74) Representative : Johnston, Kenneth Graham et
al
AT&T (UK) LTD. AT&T Intellectual Property
Division 5 Mornington Road
Woodford Green Essex, IG8 OTU (GB)

(54) Dielectric layers for integrated circuits.

(57)    In an illustrative embodiment, the present invention includes the formation of three dielectric layers (e.g., 21,27,29), one upon another, and the planarizing or etching back of the third layer (e.g., 29). Various embodiments may feature a second sandwiched layer (e.g., 35) which tends to inhibit mobile ion transport from the layer above the second layer (e.g., 37) to the layer (e.g., 21) below the second layer (e.g., 35).

FIG. 1

EP 0 485 086 A1

Jouve, 18, rue Saint-Denis, 75001 PARIS

## Technical Field

This invention relates to integrated circuit devices and fabrication methods; more particularly, it relates to devices with dielectric layers between conductors and to methods for fabricating such devices.

## Background of the Invention

Typical integrated circuit manufacturing processes involve the formation of various components such as capacitors, transistors, etc. on a substrate, and the subsequent covering of these components with dielectric layers. The dielectric layers serve a variety of functions, including electrically isolating components and devices from one another as well as providing support and isolation for overlying conductive paths which are often made from metal and/or polysilicon and termed "runners." Runners generally serve to connect individual devices within a circuit. Present-day integrated circuits may often feature several layers of runners, each layer separated from the others by a dielectric layer, all layers overlying an array of components (such as transistors, capacitors, etc.) formed upon or within a substrate.

An often pervasive problem within the semiconductor industry is mobile ion contamination. Mobile ions, such as alkali metal ions, and particularly sodium ions, are often somehow introduced, during fabrication, into the dielectric layers which separate the runners. In certain MOSFET devices these ions may eventually migrate to the substrate where they will adversely affect inter-device isolation and perhaps adversely affect device threshold voltages.

There are many potential sources of mobile ion contamination (particularly sodium), not all of them catalogued or completely understood. One possible source of contamination is the planarizing or etchback processes which are used to flatten interlevel dielectrics. (Interlevel dielectrics are frequently planarized or at least smoothed to alleviate problems associated with formation of subsequent higher levels of metal and/or dielectric.)

Certain designers have attempted to use phosphorous-doped silicon dioxide as a level 1 dielectric, believing that the phosphorous doped silicon dioxide would prevent mobile ions from reaching the substrate. However, problems with inter-device isolation and threshold voltage shifts still occur in multi-level metal technologies.

## Summary of the Invention

In an illustrative embodiment, the present invention includes the formation of at least three dielectric layers, one upon another, and the etching back of the third layer.

Various embodiments feature a second layer (sandwiched between first and third layers) which tends to inhibit mobile ion transport. The second layer helps prevent mobile ions from reaching the silicon substrate. The second layer is desirably positioned high enough above the substrate to prevent sodium-induced image charges in the substrate which will adversely affect device performance even if the sodium or other mobile ion contaminant itself has not penetrated to the substrate.

## Brief Description of the Drawing

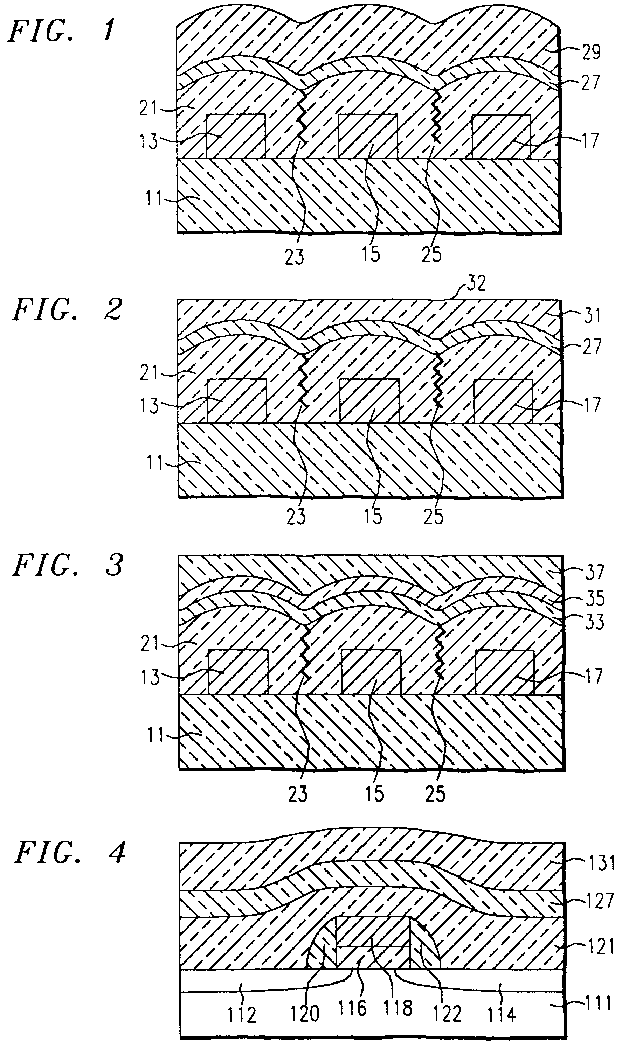

FIGs. 1-4 are cross-sectional views depicting illustrative embodiments of the present invention.

## Detailed Description

In FIG. 1 reference numeral 11 represents, typically, a dielectric material. Dielectric 11 may, illustratively, be a material which covers the gate, source, or drain of a field effect transistor (often called a "level 1 dielectric "). Details of the underlying device have been omitted in the interest of clarity. Reference numerals 13, 15, and 17 denote conductive runners which overlie dielectric 11. Runners 13, 15 and 17 may be made from metal, for example, aluminum, or from other conductive material such as polysilicon. Windows or vias which may connect runners 13, 15 and 17 to underlying active transistor regions or to underlying runners have also been omitted in the interests of clarity.

Dielectric 21 covers runners 13, 15, and 17, and generally fills the spaces between them. Dielectric 21 may be silicon dioxide. Silicon dioxide is often deposited for use as an interlevel dielectric (such as dielectric 21) via a chemical vapor deposition (CVD) process from a variety of source gases. Deposition techniques may be performed at atmospheric or low pressure and may also be plasma enhanced, if desired. Dielectric 21 may be formed from silane, if desired. Alternatively, dielectric 21 may be formed from an organosilane precursor such as tetraethoxysilane $(Si(OC_2 H_5)_4)$, with the acronym "TEOS"; tetramethoxysilane $(Si(OCH)_4)$, with the acronym "TMOS"; diacetoxyditertiarybutoxysilane $(C_{10}H_{26}O_4Si)$, with the acronym "DADBS "; and tetramethylcyclotetrasiloxane $(C_4H_{16}Si_4O_4)$ with the "TMCTS", sold under the trademark "TOMCATS" by J. C. Schumacher, a unit of Air Products and Chemicals, Inc. Other precursors and/or processes may also be used. As mentioned before, dielectric 21 may optionally contain phosphorous.

Among those skilled in the art, the expression "depositing a layer of TEOS," for example, is generally understood to mean the deposition of a dielectric layer by decomposition of TEOS in a reactor. The process may be plasma-enhanced, if desired, and then the resulting layer is denoted "PETEOS". Similar expressions are used, for example, to describe processes utilizing DADBS, TMCTS, etc. The process may also utilize NF$_3$ or ozone. Some deposition processes may employ multiple depositions and etchbacks.

The upper surface 22 of dielectric 21 is generally non-planar because the deposited dielectric tends to form a surface 22 which generally reproduces the underlying topography. Thus, surface 22 is somewhat higher above runners 13, 15, and 17, and lower in the spaces between the runners.

It is frequently desirable to smooth or planarize the upper surface 22 of dielectric 21 so that subsequent depositions of, for example, metals or dielectrics, will take place on a comparatively flat surface (thus avoiding step coverage problems often encountered when deposition is attempted upon non-smooth or undulating surfaces). Planarization of surface 22 is traditionally accomplished in a variety of ways well known in the art.

Many planarization techniques present a threat of mobile ion contamination. One planarization method employs a resist material. The resist may be deposited upon surface 22 and planarized by spinning. Then both resist and underlying dielectric are etched by processes which attack both materials at approximately the same rate. Unfortunately, many resist materials are plentiful sources of sodium. Consequently, the resist-etchback planarization process may contribute to mobile ion contamination.

An alternative planarization technique employs reactive ion etching (RIE) of upper surface 22 of dielectric 21. Although RIE etchback planarization does not employ a resist, many of the conventional RIE processes seem to introduce sodium contamination.

Consequently, after dielectric 21 has been planarized or etched back by whatever processes the fabricator deems most desirable, a wet cleaning procedure may be employed to remove sodium from the upper surface 22 of dielectric 21. For example, a wet cleaning procedure may use an 8:1 ratio of ethylene glycol and buffered HF if runners 13, 15, and 17 are metal and are exposed after dielectric 21 planarization, or a 100:1 ratio of water and HF if runners are not exposed.

The wet cleaning procedure, while desirable for removing ubiquitous sodium, poses certain hazards. Many of the CVD processes used to form dielectric 21 may fill the spaces between runners less than perfectly. If two runners, such as runners 13 and 15, are closely spaced, various imperfections denoted by reference numerals 23 and 25, may appear within dielectric 21 between rumer pairs such as 13-15 and 15-17. These imperfections may be voids or so-called soft oxide regions. A soft oxide region is an apparently solid oxide region which is vulnerable to preferential etching, for example, during the wet cleaning procedures described above. Thus, should a soft oxide region 23 exist between runners 13 and 15, a wet cleaning procedure will preferentially attack soft oxide 23, thus creating a groove within dielectric 21. Further exposure to the wet cleaning procedure will result in the transference of the groove downward into the space between runners 13 and 15. A groove is undesirable because it damages the smooth upper topography of the resulting surface and makes subsequent dielectric or metal deposition difficult.

The present invention helps to reduce the sodium contamination threat posed by planarization procedures and also eliminate the need for a wet cleaning procedure with its attendant risks should defects 23, 25 be present.

Returning to FIG. 1, dielectric 21 may be formed by deposition from the one of the aforementioned source gases by methods known to those skilled in the art to a typically desirable thickness of approximately 8000Å±4000Å or so. Alternatively, spin-on-glass or PETEOS with a subsequent deposition of B$_2$O$_3$ to help fill voids may be used. In general, it is desirable that whatever process is used, it should fill the spaces between runners reasonably well, although perfect or complete filling is not essential.

No planarization etchback procedure or wet cleaning procedure need be performed at this point. Then layer 27 is deposited. Layer 27 may be, for example, silicon nitride which may be deposited by plasma enhanced chemical vapor deposition techniques or by other methods such as low pressure chemical vapor deposition, both known to those skilled in the art. The thickness of layer 27 is desirably 2000Å ± 500Å or so. (Applicants' tests have shown that, when layer 27 is silicon nitride, a thickness of approximately 1000Å exhibits marginal performance.) Alternatively, layer 27 may be a layer of TEOS doped with 2-7% phosphorous by weight. In general, layer 27 may be any other low-temperature formed film which will serve as a sodium barrier.

After layer 27 has been formed, an additional dielectric layer 29 is formed by deposition or other methods known to those skilled in the art. Typically, though not necessarily, layer 29 may be formed from the same material as layer 21. Typically the desirable thickness of layer 29 may be 1.5μm±0.5μm.

Turning to FIG. 2, reference numeral 31 represents layer 29 after it has been etched back by techniques known to those skilled in the art which may include photoresist-planarization or reactive ion etching (RIE). Preferably, the etch-back should leave at least 1000Å of dielectric above layer 27 above the runner. Whatever technique is used, a comparatively planar surface 32 for the upper dielectric now designated 31 may be achieved. Planar surface 32 serves as a convenient platform for formation of additional levels of runners, if desired. (Thus, subsequent processing may include via creation and runner formation.) The presence of layer 27 helps to prevent mobile ions which may be introduced dig the planarization process from penetrating into dielectric 21. The precise mechanism by which layer 27 helps prevent the penetration of mobile ions is not precisely understood. It is possible that if layer 27 is phosphorous-doped TEOS (P-PETEOS), it may serve as a getter. If layer 27 is silicon nitride, it may serve as a barrier to mobile ion penetration.

A wet cleaning procedure is not necessary after the planarization step mentioned above to remove sodium ion contamination from the vicinity of surface 32. The presence of layer 27 insures that the wet cleaning step may be eliminated without fear of sodium penetrating into dielectric 21. The problem of grooves in oxides created by wet cleaning is thus also avoided. In addition, the position of layer 27 within the dielectric "sandwich" of layers 21, 27, and 31 is important in helping to prevent induced image charges in the underlying silicon.

In other words, applicants'investigations have shown that there is significance to the relative thicknesses of dielectric 21 and 31. A series of experiments was performed on separate wafers in which the thickness of layer 21 (over a silicon substrate) was varied from 0.2μm to 0.5μm to 0.8μm, while thethickness of layer 29 was varied from 0.8μm to 0.5μm to 0.2μm, the sum of thicknesses of layer 21 and 27 and 29 remaining 1.2μm. Layer 27 was silicon nitride with a thickness of 0.2μm. (Although no etchback was performed, sodium was introduced onto the upper surface of layer 29 by depositing a photoresist and then ashing it in ozone.) A TVS ("Triangular Voltage Sweep") test was performed to detect mobile ion contamination in layer 21. The TVS test is described in U.S. patent number 4,950,977 entitled "Method of Measuring Mobile Ion Concentration in Semiconductor Devices" co-assigned herewith. The least amount of ionic current was found for the sample in which the thickness of layer 21 was 0.8μm. It is hypothesized that the presence of sodium ions at or near the upper surface of layer 27 induces image charges in both the silicon substrate and in whatever metal runner may be located on top of dielectric 31. The amount of image charge seen in the silicon substrate is roughly proportioned to the thickness of dielectric 31 divided by the total dielectric thickness between metal runners on dielectric 31 and the silicon substrate. The image charges induced in the substrate contribute to the inter-device isolation problems and threshold shift problems mentioned before. Even if the level 1 dielectric (i.e., 11 in FIG. 1) is phosphorous-doped glass, the image charge phenomenon can cause the aforementioned problems.

Applicants' further investigations have shown that an important parameter is the relative position of the interface (such as the top or interior of layer 27 where sodium may accumulate) between the underlying silicon substrate and overlying metal runners.

For a given level of contamination, the interface must be sufficiently far from the silicon and close to the overlying runners so that most of the image charge appears in the runners and insufficient image charge is seen in the silicon to degrade circuit performance.

Returning to FIG. 1, layer 21 might be phosphorous-doped glass or nitride. However, undoped glass is preferred because of its considerably better step coverage.

Turning to FIG. 3, there is again illustrated runners 13, 15, and 17 overlying dielectric 11. Dielectric 21 covers runners 13, 15, and 17 and has potential imperfections 23 and 25. Layers 33 and 35 have been formed on the upper surface of dielectric 21. Layer 33 may be the aforedescribed silicon nitride layer with a thickness of approximately 0.1μm±0.05μm, while layer 35 may be the aforedescribed phosphorous-doped TEOS with a thickness of approximately 0.1μm±0.05μm. The thickness of layer 21 may illustratively be 0.8μm±0.1μm, while the thickness of layer 37 before planarization may be 1.5μm±0.5μm. Planarized dielectric layer 37 is formed on top of layer 35. The order of layers 35 and 33 may be reversed. In the instance of FIG. 3, two separate layers 35 and 33 have been formed.

The present invention may also find applicability in bipolar, BiCMOS and III-V technologies.

While nitride layers have been employed in the past as final passivation layers to prevent various types of contamination after an integrated circuit is nearly completed. The use of a nitride layer in the present application is believed novel. A final passivation layer cannot prevent mobile ions from being introduced during lower level processing. The present invention helps to eliminate problems associated with mobile ion contamination. While the use of phosphorous-doped glass as a level 1 dielectric to prevent sodium migration to active device regions is known, the use of phosphorous-doped glass in the present application is believed novel. The image charges induced in the substrate by mobile ion contamination in upper level undoped dielectrics also adversely affect device performance. The present invention, by causing most of the image charge to be induced in upper level runners and not the underlying silicon, helps to reduce the image charge problem.

The present invention has been illustrated with respect to embodiments in which the triple layer (i.e., 21, 27, 31) or quadruple layer (21, 33, 35, 37) "sandwich" with one or more barrier layers (27, 33, 35) has been positioned generally atop a dielectric layer (11). In other words, the embodiments illustrated thus far include use of the "sandwich" as a level 2 or higher dielectric. Because of the protection against induced image charges afforded by the present invention, its use is advisable even if the level 1 dielectric itself contains a mobile ion barrier.

However, the present invention may also be used as a level 1 dielectric. An example of such employment is provided by FIG. 4.

In FIG. 4 reference numeral 111 denotes a substrate which may be silicon, doped silicon, epixial silicon, etc. Reference numerals 112, 114, 116, 118, 120, and 122 denote, respectively and illustratively, source, drain, gate oxide, gate conductor, and gate spacer(s). Other device configurations are also possible. Reference numeral 121 denotes a dielectric akin to dielectric 21 of FIGs. 1-3. Dielectric 121 may, illustratively, be formed from TEOS or another organosilane precursor or from silane. Dielectric 121 may be formed by low pressure chemical vapor deposition (LPCVD TEOS) or by plasma enhanced deposition (PETEOS). (PETEOS deposition is usually preferred for level 2 and above dielectrics because of its lower temperature. The higher temperatures associated with other processes often have a deleterious effect upon aluminum runners.) Dielectric 127 is illustratively a layer of TEOS doped with approximately 4% phosphorous by weight or a layer of silicon nitride. The thickness of layer 121 is illustratively $0.8\mu m \pm 0.1\mu m$, while the thickness of layer 127 is illustratively $2000\text{Å} \pm 500\text{Å}$.

Finally, layer 131, which may illustratively be formed from TEOS, is formed above layer 127. Layer 131 may be planarized or etched back without substantial risk of introducing mobile ion contaminants into substrate 111 because of the presence of barrier 121. Runners may then be formed upon layer 131.

Furthermore, as mentioned before, the thicknesses illustratively chosen for layers 121, 127, and 131 will serve to reduce the possibility of image charge interference with transistor operation. As mentioned before, the amount of charge imaged in the silicon is roughly proportional to the thickness of dielectric 131 divided by the total thickness between metal runners on dielectric 131 and the silicon substrate. In the example of FIG. 4, the "total thickness" is the sum of the thicknesses of layers 131, 127, and 121. In the example of FIG. 2, the "total thickness" is the sum of the thicknesses of layers 31, 27, 21, 11, and whatever other layers may exist between layer 11 and the silicon substrate.

Consequently, the relative placement of layer 127 in FIG. 4 (i.e., the relative thicknesses of layers 131 and 121) is somewhat more important when the sandwich is employed as a level 1 dielectric than when it is employed at higher levels. When the sandwich is employed at higher levels, the extra layers of dielectric below the sandwich help to reduce the amount of charge imaged in the silicon, per the above-mentioned formula. When the sandwich is employed at higher levels, the thickness of layer 21 (e.g., in FIG. 2) may be reduced to approximately $0.5\mu m$ and the thickness of layer 21 increased to approximately $0.5\mu m$ if desired.

One might be tempted to reduce the thickness of layers 31 or 131 to zero (i.e., to eliminate these layers) to also reduce the induced image charge in the silicon to zero. However, applicants' investigations have shown that it is generally inadvisable to leave nitride layers such as 27 or 127 exposed. Although the precise mechanism is not understood, applicants hypothesize that when the nitride layer such as 27 or 127 is exposed, the resulting bilayer dielectric is leakier than a corresponding three-level dielectric in which the nitride is covered with, for example, about $0.1\text{-}0.2\mu m$ of oxide.

## Claims

1. A method of semiconductor integrated circuit fabrication comprising:

   forming a first dielectric layer (e.g., 21) upon a substrate (e.g., 11); AND CHARACTERIZED BY

   forming a second dielectric layer (e.g., 27) upon said first dielectric layer (e.g., 21), said second dielectric (e.g., 27) being a material capable of substantially inhibiting mobile ion transport;

   forming a third dielectric layer (e.g., 29) upon said second dielectric layer (e.g., 27),

   at least partially etching back said third layer (e.g., 29).

2. The process of claim 1 further including the step of forming said first (e.g., 21), second (e.g., 27) and third (e.g., 29) layers with thicknesses sufficient to prevent substantial image charge inducement in said substrate to adversely affect circuit performance.

3. The process of claim 1 in which said first dielectric layer (e.g., 21) is formed from precursors chosen from the group consisting of silane, TEOS, TMOS, DADBS, and TMCTS.

4. The process of claim 1 in which said substrate (e.g., 11) is a material chosen from the group consisting of silicon and silicon dioxide.

5. The process of claim 1 in which said second dielectric layer (e.g., 27) is chosen from the group consisting of silicon nitride, and silicon dioxide doped with phosphorous.

6. The process of claim 1 in which said third dielectric layer (e.g., 29) is formed from precursors chosen from the group consisting of silane, TEOS, TMOS, DADBS, and TMCTS.

7. The process of claim 1 in which said etching back step is accomplished by reactive ion etching.

8. The process of claim 1 in which said etching back step is accomplished by depositing and leveling a resist material and then etching both said resist and said third dielectric layer.

9. The process of claim 1 in which a fourth layer (e.g., 35) is formed upon said second layer (e.g., 33), before formation of said third layer (e.g., 37), and said fourth layer (e.g., 35) is a dielectric chosen from the group consisting of silicon nitride and silicon dioxide doped with phosphorous.

10. The method of claim 1 in which said first layer (e.g., 21) is made from TEOS and covers at least one conductive runner (e.g., 13) and has a thickness of $0.8\mu m \pm 0.1\mu m$;

said second layer (e.g., 27) is made from silicon nitride and has a thickness of $0.2\mu m \pm 0.05\mu m$;

said third layer (e.g., 29) is made from TEOS and has an initial thickness of $1.5\mu m \pm 0.5\mu m$;

said third layer (e.g., 29) is partially etched back, leaving at least a thickness of $0.1\mu m$ above said runner (e.g., 13); and

at least one second conductive runner is formed upon said third layer.

FIG. 1

FIG. 2

FIG. 3

FIG. 4

**European Patent Office**

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0 323 103 (DOW CORNING)<br>* page 5, line 21 - line 27 *<br>--- | 1,4,7,8 | H01L23/485<br>H01L21/90 |
| Y | JAPANESE JOURNAL OF APPLIED PHYSICS.<br>vol. 27, no. 2, February 1988, TOKYO JP<br>pages 280 - 286;<br>MAYUMI ET AL: 'Etch-back planarization technique for multilevel metallization'<br>* figure 1 *<br>--- | 1,4,5,7,8 | |
| Y | IBM TECHNICAL DISCLOSURE BULLETIN.<br>vol. 33, no. 3A, August 1990, NEW YORK US<br>pages 3 - 4;<br>ANONYMOUS: 'Composite planarization barrier'<br>* the whole document *<br>--- | 1,4,5 | |
| Y | IBM TECHNICAL DISCLOSURE BULLETIN.<br>vol. 27, no. 8, January 1985, NEW YORK US<br>pages 4700 - 4701;<br>BEYER ET AL: 'Glass planarization by stop-layer polishing'<br>* the whole document *<br>--- | 1,4,5 | **TECHNICAL FIELDS SEARCHED (Int. Cl.5 )** |
| A | US-A-4 614 666 (SPERRY)<br>* column 1, line 26 - line 46; figures *<br>--- | 1,4,5 | H01L |
| A | EP-A-0 008 928 (FUJITSU)<br>* page 3, line 11 - line 23; figures *<br>--- | 1,4,5 | |
| A | PHILIPS JOURNAL OF RESEARCH.<br>vol. 44, no. 2-3, 28 July 1989, EINDHOVEN NL<br>pages 257 - 293;<br>OSINSKI ET AL: 'A 1um CMOS process for logic applications'<br>* page 272, paragraph 2; figure 1 *<br>--- | 1,3,6,10 | |

-/--

The present search report has been drawn up for all claims

| Place of search | Date of completion of the search | Examiner |
|---|---|---|
| THE HAGUE | 03 MARCH 1992 | GORI P. |

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | SOLID STATE TECHNOLOGY. vol. 27, no. 5, May 1984, WASHINGTON US pages 155 - 161; MASTROIANNI: 'Multilevel metallization device structures and process options' * page 158, left column, paragraph 2 - right column; figure 6 * | 2,9 | |
| A | US-A-3 967 310 (HITACHI) * claims * | 2,9 | |
| | | | **TECHNICAL FIELDS SEARCHED (Int. Cl.5)** |

The present search report has been drawn up for all claims

| Place of search | Date of completion of the search | Examiner |
|---|---|---|
| THE HAGUE | 03 MARCH 1992 | GORI P. |

EPO FORM 1503 03.82 (P0401)